# Europäisches Patentamt

## European Patent Office

## Office européen des brevets

(11) Veröffentlichungsnummer: **0 174 050**
**B1**

## EUROPÄISCHE PATENTSCHRIFT

(45) Veröffentlichungstag der Patentschrift: **31.10.90**

(21) Anmeldenummer: **85201375.4**

(22) Anmeldetag: **30.08.85**

(51) Int. Cl.⁵: **H 05 K 7/02**, H 05 K 13/06, H 01 R 43/28

(54) **Verfahren und Vorrichtung zum Ordnen und Ausrichten flexibler, isolierter Leiter.**

(30) Priorität: **06.09.84 DE 3432735**

(43) Veröffentlichungstag der Anmeldung:
**12.03.86 Patentblatt 86/11**

(45) Bekanntmachung des Hinweises auf die
Patenterteilung:
**31.10.90 Patentblatt 90/44**

(84) Benannte Vertragsstaaten:
**DE FR GB IT**

(56) Entgegenhaltungen:
EP-A-0 044 636
EP-A-0 121 223
FR-A-2 507 853
US-A-3 459 878
US-A-3 872 567

(73) Patentinhaber: **Philips Patentverwaltung GmbH
Wendenstrasse 35 Postfach 10 51 49
D-2000 Hamburg 1 (DE)**
(84) **DE**

(73) Patentinhaber: **N.V. Philips'
Gloeilampenfabrieken
Groenewoudseweg 1
NL-5621 BA Eindhoven (NL)**
(84) **FR GB IT**

(72) Erfinder: **Thenner, Günther
Watzenborner Weg 14
D-6300 Giessen (DE)**

(74) Vertreter: **Kupfermann, Fritz-Joachim, Dipl.-Ing.
et al
Philips Patentverwaltung GmbH Wendenstrasse
35 Postfach 10 51 49
D-2000 Hamburg 1 (DE)**

Courier Press, Leamington Spa, England.

**Beschreibung**

Die Erfindung bezieht sich auf ein Verfahren zum Ordnen und Ausrichten flexibler, isolierter Leiter eines ungeordneten elektrischen Leiterbündels in eine geordnete gegenseitige Stellung vor dem Anlöten der abisolierten Leiterenden an Leitungszüge eines Kontaktbauteiles sowie auf eine Vorrichtung zur Durchführung dieses Verfahrens und zur Bildung eines Knickschutzes von mittels des Verfahrens festgelegten und danach an dem Kontaktbauteil angelöteten Leitern.

In der elektrischen Schaltungstechnik werden häufig Schaltungsplatten miteinander über flexible Leiter verbunden. Zur Vereinfachung und zur Verbesserung der Übersichtlichkeit derartiger Verbindungen ist es bekannt, mehrere Leiter zu einem sogenannten Bandleiter zusammenzufassen, wobei dann die Isolierungen der nebeneinanderliegender Leiter über Isolationsmaterialbrücken miteinander verbunden sind. Derartige Bandleiter haben eine gewisse Steifigkeit, die es verhindert, die Bandleiter auch in stark geknicktem Zustand einzusetzen. Insbesondere in Autoradios, in denen es auf eine außerordentlich gedrängte Bauweise ankommt, lassen sich Bandleiter nur schwierig einsetzen. Werden einzelne Leiter eingesetzt, dann muß den Verbindungen besondere Aufmerksamkeit geschenkt werden, da die einzelnen Leiter von Hause aus in keiner besonderen Ordnung an der jeweiligen Anlötstelle ankommen.

Es ist aus der US—A—3 459 878 bekannt, geordnete Leiter durch das Eindrücken zwischen Zinken von Kämmen in einer gewünschten in Ordnung zu halten. Die Ordnung des Leiter wird aber schon vor den Kämmen durch ein Inderierungsband geschaffen.

Es ist Aufgabe der Erfindung, ein Verfahren der eingangs erwähnten Art zu schaffen, bei dem die Zuordnung der einzelnen Leiter zu den Anlötstellen rasch und ohne Komplikationen herstellbar ist, sowie eine Vorrichtung, mit der das Verfahren durchführbar ist.

Die gestellte Aufgabe ist erfindungsgemäß dadurch gelöst, daß die ungeordneten Leiter von einer geordneten Stelle her zwischen fluchtenden Zinken von hintereinander fluchtend angeordneten, nicht-metallischen Kämmen hindurchgezogen werden, bis die jeweiligen Übergänge von den isolierten zu den abisolierten Leiterabschnitten gerade den ersten Kamm passiert haben, und daß die Leiter dann in Verengungen zwischen den Zinken sich dort positionierend oder verklemmend eingedrückt werden so daß die Ordnung zwischen den Zinken der Kämme erfolgt. Die einzelnen Leiter werden also wie Haare von einer Ordnungsstelle her durch die Kämme gezogen, do daß die abisolierten Enden letztlich in genauer gegenseitiger Zuordnung und an den genau vorgegebenen Stellen mit dem Kontaktbauteil, beispielsweise einer Printplatte, verlötet werden können. Dieser Arbeitsvorgang ist einfach und sicher.

Zur Durchführung des Verfahrens dient eine Vorrichtung mit wenigstens zwei fluchtend hintereinander angeordneten, nicht-metallischen Kämmen, die über eine Fußleiste miteinander verbunden sind. Die Vorrichtung ist dadurch gekennzeichnet, daß sich die fluchtenden Zinken zur Fußleiste hin gegeneinander verbreitern zur Ausbildung von Verengungen im Bereich der Zinkenfüße. In den oberen Teilen liegen die Zinken dabei so weit auseinander, daß die Leiter leicht hindurchgezogen werden können. Ist das Durchziehende erreicht, dann werden sie zwischen die Verengungen gedrückt und sitzen dort klemmend fest.

Um die gewünschte Klemmung berbeizuführen, ist nach einer weiteren bevorzugten Ausgestaltung der Vorrichtung vorgesehen, daß die Verengungen des zweiten Kammes, in denen die Leiter mit ihren isolierten Abschnitten festgeklemmt werden, in ihrer Breite knapp dem Durchmesser der Isolation entsprechen.

Die Verengungen des ersten Kammes, in denen die abisolierten Enden der Leiter zu liegen kommen, sind dagegen in ihrer Breite so bemessen, daß sie diese nur exakt auf dem Abstand halten, den entsprechende Lötschlitze auf der Leiterplatte haben.

Im fertig eingebauten Zustand, wenn die Leiter auf die Printplatte gelötet sind, dient die Vorrichtung als Knickschutz für die Leiter unmittelbar über der Printplatte. Diese Stellen sind bei durchkontaktierten Leiterplatten besonders vom Knickbruch gefährdet, da das Lötzinn durch die Löcher der Leiterplatte nach oben steigt, dort die einzelnen Litzen miteinander verbäckt und ihnen dadurch nach dem Erstarren des Lötzinnes die Flexibilität nimmt. Eine Biegebelastung wird durch die Vorrichtung im eingebauten Zustand in den Bereich des zweiten Kammes verlagert und damit en eine Stelle, die vom flüssigen Lötzinn nicht erreicht werden kann.

Nach einer weiteren bevorzugten Ausgetaltung der Erfindung ist vorgesehen, daß die Kammteilung der Leiterabstand bei Bandleitern entspricht. Man kann deshalb die Vorrichtung auch bei Bandleitern als Knickschutz einsetzen.

Nach einer weiteren bevorzugten Ausgestaltung der Erfindung ist vorgesehen, daß am ersten Kamm, dessen Außenfläche als Auflage an dem Kontaktbauteil vorgesehen ist, mit Nocken versehen ist, die beim Aufschieben der Vorrichtung auf den Kontaktbauteil als Anschlag dienen. Mit Hilfe dieser Nocken läßt sich die Vorrichtung exakt und sicher auf einer Schaltungsplatte feststecken, so daß die Leiter bis zum Anlöten mit Hilfe der Vorrichtung an der Schaltungsplatte festgehalten werden.

Die Erfindung wird anhand des in der Zeichnung dargestellten Ausführungsbeispieles näher erläutert. Es zeigen:

Fig. 1 eine schaubildliche Darstellung eines Teiles einer Vorrichtung zur Durchführung des Verfahrens nach der Erfindung.

Fig. 2 eine Draufsicht auf die Vorrichtung zur Darstellung des Festklemmens der Leiter.

Fig. 3 den Ablauf des Montagevorganges bis zum Löten.

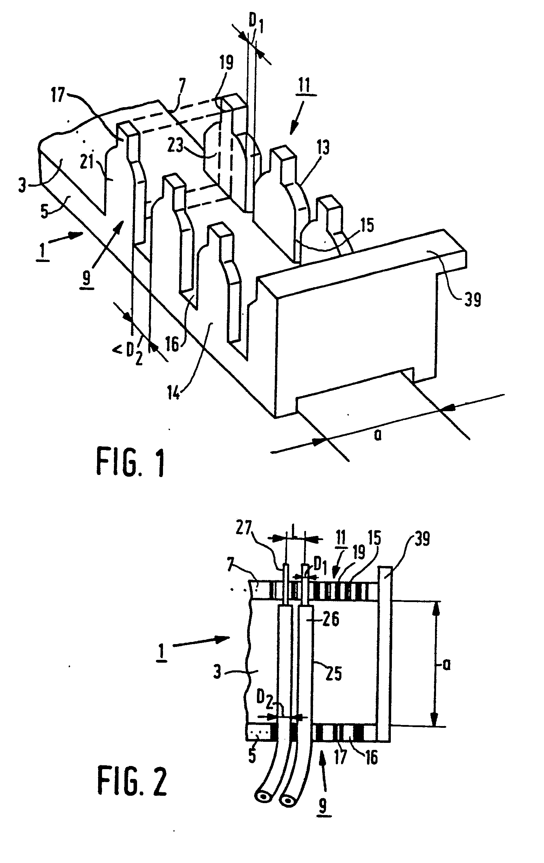

Fig. 1 zeigt schaubildlich eine Vorrichtung, die sich eignet, ungeordnete einzelne elektrische Leiter von einer Ordnungsstelle, beispielsweise einem Stecker, her zu ordnen, um sie dann an einer gewünschten Stelle in gegenseitiger Ordnung weiter bearbeiten oder verarbeiten zu können. Diese Vorrichtung 1 besteht aus einer Kunststoff-Fußleiste 3, an deren Längsseiten 5, 7 Kunststoff-Kämme 9, 11 mit Zinken 13, 14 angeordnet sind. Die Zinken 13, 14 stehen dazu in zwei Reihen senkrecht von der Fußleiste 3 ab. Die Zinken 13, 14 bestehen aus oberen schlanken Zinkenteilen 17, 19, die über bogenförmige Übergänge gleitend in Zinkenfüße 21, 23 übergehen. Der gegenseitige Abstand der oberen schlanken Zinkenteile 17 und 19 ist so gewählt, daß elektrische Anschußleitungen 25 mit Spiel zwischen ihnen hindurchgezogen werden können.

Im Bereich der Zinkenfüße 23 haben die Zinken 13 des Kammes 11 gegenseitige Abstände, die ein wenig größer sind als der Durchmesser $D_1$ der abisolierten Teile der elektrischen Leiter 25. Die Zinkenfüße 21 der Zinken 14 haben einen gegenseitigen Abstand, der kleiner ist als die Durchmesser $D_2$ der isolierten Anschnitte 26 der elektrischen Leiter 25. Aufgrund dieser Durchmesserverhältnisse von $D_1$ und $D_2$ zwischen dem Leiter 25 und den Zinken der Kämme 9 bzw. 11 ist es möglich, beim Eindrücken der Leiter bis zu den Verengungen 15, 16 die Leiter 25 zwischen den Zinken 14 klemmend festzulegen und die abisolierten Enden 27 der Leiter 25 zwischen den Zinken 13 zu positionieren.

In Fig. 2 ist der Abstand zwischen zwei einzulegenden Drähten 25 mit 1 angegeben. Dieser Abstand muß nicht unbedingt eingehalten werden. Er kann dem Abstand zweier Leiter 25 einer Bandleitung entsprechen. Auf diese Weise ist es möglich, auch eine Bandleitung in der Vorrichtung 1 festzuklemmen und die Vorrichtung damit als Knickschutz einzusetzen.

In Fig. 1 ist die Vorrichtung stark vergrößert dargestellt, ebenso wie die gegenseitigen Abstände der Zinken und deren Breite stark vergrößert angegeben ist. In Fig. 2 sind die Leiter mehr den tatsächlichen Gegebenheiten dicht beieinander angeordnet.

Wenn eine Anzahl von einzelnen Leitern 25 von einer nicht dargestellten Ordnungsstelle, beispielsweise einem Stecker, her ungeordnet endet, dann wird die Vorrichtung 1 im Bereich dieser Ordnungsstelle und die Leiter 25 gesteckt, so daß diese von der Ordnungsstelle her auch in den Kämmen 9, 11 geordnet liegen. Die Leiter 25 werden dann durch die Kämme gezogen, und zwar so lange, bis die abisolierten Enden 27 die Zinken des ersten Kammes 11 passiert haben. Ist dies erreicht, dann werden die Leiter 25 in die Verengungen 15, 16 zwischen den Zinken 13, 14 eingedrückt. Auf diese Weise sind die ungeordneten Leiter 25 eines Leiterbündels geordnet und ausgerichtet, so daß sie ohne Schwierigkeiten in vorgegebene Anschlußschlitze einer Schaltungsplatte seitlich aufgeschoben werden können.

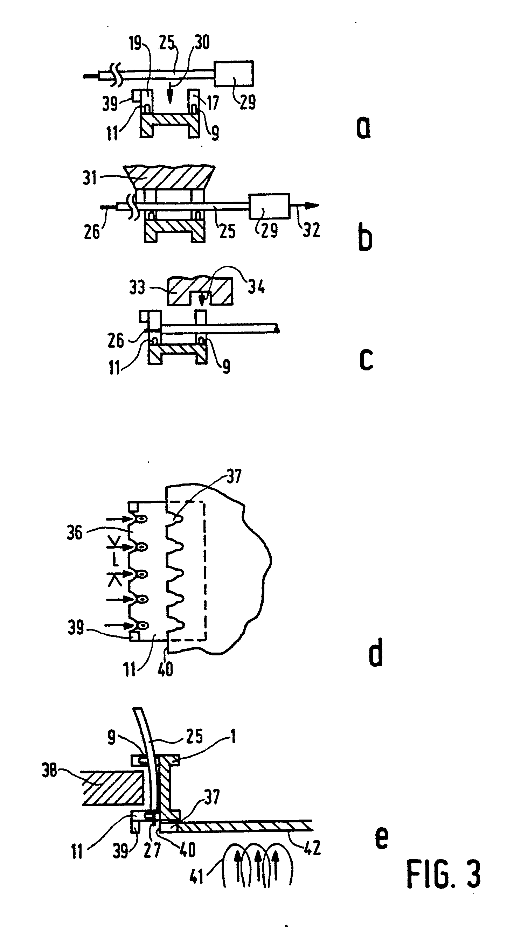

In Fig. 3a bis 3e sind die einzelnen Schritte zum Ordnen der Leiter 25 bis zum Anbringen der Vorrichtung zusammen mit den Leitern an einer Leiterplatte dargestellt. An einem Stecker 29 ist eine Reihe von Leitern (nur der vorderste Leiter 25 ist dargestellt) angeordnet. Die Leiter 25 werden kann in Richtung eines Pfeiles 30 zwischen die schlanken Zinkenteile 17, 19 gelegt. Diese Lage ist aus Fig. 3b zu erkennen. Nun wird der Stecker 29 nach dem Auflegen einer Abdeckung 31 in Richtung eines Pfeiles 32 gezogen, wobei sich die einzelnen Leiter 25 ordnen. Das Durchziehen ist beendet, wenn die sich abisolierten Enden 27 der Leiter 25 gerade im Kamm 11 befinden. Diese Lage ist aus Fig. 3c zu entnehmen. Nun wird ein Klemmwerkzeug 33 in Richtung eines Pfeiles 34 auf die Leiter 25 gedrückt; die isolierten Leiter werden dabei in die Verengungen 16 des Kammes 9 gedrückt. Dies ist aus Fig. 3c zu entnehmen.

Die Leiter 25 mit der Vorrichtung 1 sollen an nicht dargestellte Leitungszüge einer als Kontaktbauteil dienenden Leiterplatte 35 angelötet werden. Die Leiterplatte ist am Bestückungsrand 36 mit Schlitzen 37 versehen, deren gegenseitiger Abstand den Abstand L der abisolierten Enden 27 der Leiter 25 entspricht (Fig. 3d). Mit Hilfe eines Hilfswerkzeuges 38 wird die Vorrichtung 1 mit den Leitern 25 auf die Leiterplatte 35 aufgeschoben, bis Nocken 39 der Vorrichtung 1 gegen die Vorderkante 40 der Leiterplatte 35 stoßen. Die abisolierten Enden 27 der Leiter 25 liegen dabei in den Schlitzen 37. Durch einen geeigneten Lötvorgang, der durch Lotwellen 41 angedeutet ist, werden die Enden 27 mit Leitungszügen 42 der Schaltungsplatte verlötet.

Wie sich aus Fig. 1 und 2 ergibt, haben die beiden Kämme 9, 11 einen gegenseitigen Abstand a. Dieser Abstand ist so gewählt, daß er zwischen dem ersten und dem zweiten Kamm 9 so groß ist, daß in den isoliert bleibenden Leiterabschnitten 26 hochsteigendes flüssiges Lot den Bereich des zweiten Kammes 9 nicht erreichen kann. Im eingebauten oder gelöteten Zustand wird bei einer eventuellen späteren Biegebelastung der Leiter 25 damit dafür gesorgt, daß die Leiter an der Stelle, an der die Biegebelastung auftritt, flexibel bleiben. Dadurch wird Kabelbruch vermieden.

**Patentansprüche**

1. Verfahren zum Ordnen und Ausrichten flexibler, isolierter Leiter eines ungeordneten elektrischen Leiterbündels in eine geordnete gegenseitige Stellung vor dem Anlöten der abisolierten Leiterenden an Leitungszüge eines Kontaktbauteiles, wobei die ungeordneten Leiter von einer geordneten Stelle her zwischen fluchtenden Zinken von hintereinander fluchtend angeordneten, nicht-metallischen Kämmen hindurchgezogen werden, bis die jeweiligen Übergänge von den isolierten zu den abisolierten Leiterabschnitten gerade den ersten Kamm passiert haben, und wobei die Leiter dann in Verengungen zwischen den Zinken sich dort positionierend bzw. verklemmend eingedrückt werden, so dab die Ordnung zwischen den Zinken der Kämme erfolgt.

2. Vorrichtung zur Durchführung des Verfahrens nach Anspruch 1 und zum Knickschutz von an das Kontaktbauteil angelöteten Leitern mit wenigstens zwei fluchtend hintereinander angeordneten, nicht-metallischen Kämmen (9, 11), die über eine Fußleiste (3) miteinander verbunden sind, dadurch gekennzeichnet, daß sich die fluchtenden Zinken (13, 14) zur Fußleiste (3) hin gegeneinander verbreitern zur Ausbildung von Verengungen (15, 16) im Bereich der Zinkenfüße (21, 23).

3. Vorrichtung nach Anspruch 2, dadurch gekennzeichnet, daß die Verengungen (15) des ersten Kammes (11), in denen die abisolierten Leiterenden (27) zu liegen kommen, in der Breite gut dem abisolierten Leiterdurchmesser ($D_1$) entsprechen, um so die abisolierten Enden zu positionieren, und daß die Verengungen (16) des zweiten Kammes (9), in denen die Leiter (25) mit ihren isolierten Leiteranschnitten (26) zu liegen kommen, in der Breite knapp dem Durchmesser ($D_2$) der isolierten Leiter (25) entsprechen, um die isolierten Leiterabschnitte festzuklemmen.

4. Vorrichtung nach den Ansprüchen 2 und 3, dadurch gekennzeichnet, daß der Abstand (a) zwischen dem ersten (11) und dem zweiten Kamm (9) so groß ist, daß in den isoliert bleibenden Leiteranschnitten (26) hochsteigendes flüssiges Lot den Bereich des zweiten Kammes (9) nicht erreichen kann.

5. Vorrichtung nach den Ansprüchen 2 und 3, dadurch gekennzeichnet, daß der mittlere gegenseitige Abstand (1) der Verengungen (15, 16) dem gegenseitigen Abstand der Leiter (25) in einem Bandleiter entspricht.

6. Vorrichtung nach den Ansprüchen 2 bis 4, dadurch gekennzeichnet, daß am ersten Kamm (11), dessen Außenfläche (28) als Auflage an dem Kontaktbauteil vorgesehen ist, mit Nocken (31) versehen ist, bei beim Aufschieben der Vorrichtung auf das Kontaktbauteil (35) als Anschlag dienen.

## Revendications

1. Procédé de positionnement et de redressage de conducteurs isolés flexibles d'un faisceau de conducteurs électriques non positionnés, dans une position mutuelle positionnée, avant la fixation par soudure des extrémités dénudées des conducteurs à des conducteurs d'un élément de contact, procédé suivant lequel, à partir d'un endroit positionné, les conducteurs non positionnés sont tirés entre des dents alignées de peignes non métalliques disposés en ligne droite l'une derrière l'autre, jusqu'à ce que les transitions des parties isolées aux parties dénudées des conducteurs aient juste dépassé le premier peigne et, ensuite, les conducteurs sont pressés dans des rétrécissements entre les dents de façon à y être coincés, de sorte que le positionnement a lieu entre les dents du peigne.

2. Dispositif pour mettre en oeuvre le procédé selon la revendication 1 et pour protéger contre le flambage des conducteurs fixés par soudage à l'élément de contact, comportant au moins deux peignes non métalliques disposés l'une derrière l'autre (9, 11) et réunis par une plaque de base (3), caractérisé en ce que les dents alignées (13, 14) s'élargissent vers la plaque de base (3) de façon à former des rétrécissements (15, 16) à l'endroit de la base (21, 23) des dents.

3. Dispositif selon la revendication 2, caractérisé en ce que les rétrécissements (15) du premier peigne (11) dans lesquels viennent se situer les extrémités dènudées (27) des conducteurs, correspondent bien en largeur au diamètre ($D_1$) des extrémités dénudées des conducteurs de façon à positionner les extrémités dénudées, et en ce que les rétrécissements (16) du deuxième peigne (9) dans lesquels viennent se situer les parties isolées (26) des conducteurs (25) correspondent tout juste en largeur au diamètre ($D_2$) des conducteurs isolés (25) de façon à serrer les parties isolées des conducteurs.

4. Dispositif selon les revendications 2 et 3, caractérisé en ce que la distance (a) séparant les premier (11) et deuxième (9) peignes est suffisamment grande pour que de la soudure liquide montant dans les parties (26) des conducteurs qui restent isolées ne puisse pas atteindre l'endroit du deuxième peigne (9).

5. Dispositif selon les revendications 2 et 3, caractérisé en ce que l'écartement moyen (1) des rétrécissements (15, 16) correspond à l'écartement des conducteurs (25) dans un câble à ruban.

6. Dispositif selon les revendications 2 à 4, caractérisé en ce que le premier peigne (11) dont la surface extérieure (28) sert d'appui à l'élément de contact, est pourvu de bossage (31) servant de butée lors du glissement du dispositif sur l'élément de contact (35).

## Claims

1. A method of ranging and guiding flexible, insulated conductors of a non-ranged bundle of electrical conductors into a ranged mutual position before soldering the stripped ends of the conductors to conductive portions of a contact component, from a ranged position the non-ranged conductors being pulled between flush teeth of flush, non-metallic combs arranged one behind the other until the transitions from the insulated to the stripped ends of the conductors have just passed the first comb, whereupon the conductors are pressed so as to be positioned or clamped in narrow spaces between the teeth, so that alignment takes place between the teeth of the combs.

2. A device for implementing the method claimed in Claim 1 and for guarding against buckling of conductors soldered to the contact component, comprising at least two flush non-metallic combs (9, 11) arranged one behind the other and interconnected via a base strip (3), characterized in that the flush teeth (13, 14) become wider towards the base strip (3) so as to form narrow spaces (15, 16) at the base (21, 23) of the teeth.

3. A device as claimed in Claim 2, characterized in that the width of the narrow spaces (15) of the first comb (11) in which the stripped conductor ends (27) are to be situated, corresponds well to the diameter ($D_1$) of the stripped conductor ends so as to position the stripped ends, and in that the width of the narrow spaces (16) of the second comb (9) in which the conductors (25) are to be situated with their insulated parts (26) is just smaller than the diameter ($D_2$) of the insulated conductors (25) in order to clamp the insulated parts of the conductors.

4. A device as claimed in the Claims 2 and 3, characterized in that the distance (a) between the first (11) and the second (9) comb is so large that at the parts (26) of the conductors that remain insulated rising liquid solder cannot reach the area of the second comb (9).

5. A device as claimed in the Claims 2 and 3, characterized in that the mean spacing (1) between the narrow spaces (15, 16) corresponds to the spacing of the conductors (25) in a strip cable.

6. A device as claimed in Claims 2 to 4, characterized in that the first comb (11) whose outer surface (28) serves as a support for the contact component is provided with cams (31) which serve as stops when the device is fitted onto the contact component (35).

FIG. 1

FIG. 2

FIG. 3